(19) Europäisches Patentamt
European Patent Office
Office européen des brevets

(11) EP 2 619 250 B1

(12) # EUROPÄISCHE PATENTSCHRIFT

(45) Veröffentlichungstag und Bekanntmachung des Hinweises auf die Patenterteilung:
**15.08.2018 Patentblatt 2018/33**

(21) Anmeldenummer: **11763850.2**

(22) Anmeldetag: **23.09.2011**

(51) Int Cl.:
***C08G 77/38*** *(2006.01)* ***C08L 83/10*** *(2006.01)*
***H01L 21/00*** *(2006.01)*

(86) Internationale Anmeldenummer:
**PCT/EP2011/004782**

(87) Internationale Veröffentlichungsnummer:
**WO 2012/038093 (29.03.2012 Gazette 2012/13)**

(54) **DIELEKTRISCHE POLYMERE MIT ERHÖHTER PERMITTIVITÄT, VERFAHREN ZU DEREN HERSTELLUNG SOWIE VERWENDUNGSZWECKE HIERVON**

DIELECTRIC POLYMERS WITH ELEVATED PERMITTIVITY, PROCESS FOR PREPARATION THEREOF AND END USES THEREOF

POLYMÈRES DIÉLECTRIQUES À PERMITTIVITÉ ÉLEVÉE, PROCÉDÉ DE PRODUCTION DE CES POLYMÈRES ET APPLICATIONS ASSOCIÉES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **23.09.2010 DE 102010046343**

(43) Veröffentlichungstag der Anmeldung:
**31.07.2013 Patentblatt 2013/31**

(73) Patentinhaber: **Fraunhofer-Gesellschaft zur Förderung der angewandten Forschung e.V.**
**80686 München (DE)**

(72) Erfinder:
- **KRÜGER, Hartmut**
  **12163 Berlin (DE)**
- **KUSSMAUL, Björn**
  **13585 Berlin-Spandau (DE)**
- **KOFOD, Guggi**
  **2200 Copenhagen (DK)**
- **RISSE, Sebastian**
  **14471 Potsdam (DE)**

(74) Vertreter: **Pfenning, Meinig & Partner mbB**
**Patent- und Rechtsanwälte**
**Theresienhöhe 11a**
**80339 München (DE)**

(56) Entgegenhaltungen:
**EP-A1- 0 415 278** **US-A- 5 298 588**
**US-A1- 2003 052 576**

- **FAN-BAO MENG ET AL: "Synthesis and characterization of side-chain liquid-crystalline polysiloxanes containing fluorinated units", COLLOID AND POLYMER SCIENCE ; KOLLOID-ZEITSCHRIFT UND ZEITSCHRIFT FÜR POLYMERE, SPRINGER, BERLIN, DE, Bd. 286, Nr. 8-9, 11. März 2008 (2008-03-11), Seiten 873-879, XP019628589, ISSN: 1435-1536**
- **PORTUGALL, M., RINGSDORF, H. AND ZENTEL, R.: "Synthesis and phase behaviour of liquid crystalline polyacrylates", DIE MAKROMOLEKULARE CHEMIE, Bd. 183, Nr. 10, 18. Oktober 1982 (1982-10-18), Seiten 2311-2321, XP002665030, DOI: DOI: 10.1002/macp.1982.021831003**
- **FINKELMANN, H., KOCK, H.-J. AND REHAGE,: "Investigations on liquid crystalline polysiloxanes 3. Liquid crystalline elastomers - a new type of liquid crystalline material", DIE MAKROMOLEKULARE CHEMIE, RAPID COMMUNICATIONS, Bd. 2, Nr. 4, 15. Juni 1981 (1981-06-15), Seiten 317-322, XP002665031, DOI: DOI: 10.1002/marc.1981.030020413**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 2 619 250 B1

## Beschreibung

Die vorliegende Erfindung betrifft Verwendungszwecke eines Polymers, das einen kovalent an das Polymergerüst gebundenen elektronischen Dipol aufweist. Bei dem Polymergerüst, das dem Polymeren zugrunde liegt, handelt es sich insbesondere um ein Elastomer, das unverzweigt, aber auch verzweigt bzw. vernetzt ausgebildet sein kann.. Das erfindungsgemäße Polymer kann als Reinsubstanz, aber auch als Mischung mit beliebigen anderen Polymeren, bevorzugt mit weiteren Elastomeren, vorliegen.

In der Robotik, der Orthopädie und anderen Gebieten gibt es einen Bedarf für elektrisch kontrollierbare "künstliche Muskeln". Die Entwicklung von intelligenten Konstruktionen, wie Minimalenergieaktoren oder Stapelaktoren mit sehr kleinen Schichtdicken, sind erforderlich, um die bestmögliche Leistungscharakteristik zu erhalten. Es besteht ein großes Interesse an elektroaktiven Polymeraktoren, die elektrische Energie in lineare mechanische Bewegung umwandeln können. Obwohl bereits Aktoren entwickelt wurden, die Auslenkungen von mehr als 100 % vollführen konnten, sind jedoch verlässliche und wiederholbare relative Dehnungen von 10 bis 20 % der derzeitige Stand der Wissenschaft. Auch diese relativen Dehnungen benötigen eine Betriebsspannung von mehreren tausend Volt.

Aufgrund dieser hohen Betriebsspannungen, die unpraktisch und unsicher sind, forschen Wissenschaftler nach Materialien, die auch bei niedrigeren Spannungen betrieben werden können. Die Aktivität eines Aktors kann verbessert werden, indem seine Fähigkeit zur Speicherung der elektrischen Energiedichte verbessert wird. Dies entspricht der Erhöhung der Permittivität $\varepsilon_r$ des aktiven Materials. Viele Ansätze führten zu einer Verschlechterung der mechanischen Eigenschaften und erniedrigten Durchbruchsfeldstärken, oberhalb derer das Material einen katastrophalen elektrischen Durchbruch erleidet.

Dielektrische Elastomere sind als Basismaterialien für künstliche Muskeln und Aktorikanwendungen geeignet. Als mögliche Materialklassen werden hauptsächlich Polyurethan(PU)- und Polydimethylsiloxan(PDMS)-Elastomere diskutiert. Durch die Vielzahl für die PU- und PDMS-Synthese geeigneter Basisstrukturen lassen sich die mechanischen Eigenschaften der genannten Polymere an die Anforderungen künstlicher Muskeln und Aktorikelemente gut anpassen. Die Permittivität der genannten Polymerstrukturen ist jedoch in der Regel auf Werte von bis zu 3 beschränkt. Dadurch ergeben sich für aus diesen Materialien gefertigte künstliche Muskeln und Aktorikelemente Schaltspannungen von in der Regel > 1 kV. Diese hohen Schaltspannungen setzen der Anwendbarkeit dieser Technologie enge Grenzen. Daher sind verschiedene technische Vorschläge und Lösungen unterbreitet worden, die zu einer deutlichen Anhebung der Permittivität führen. So kann durch Blenden der genannten Polymere mit Nanopartikeln hochpermittiver anorganischer Materialien, wie Bariumtitanat, Bleizirkonat, Titandioxid u.a., die Permittivität der Elastomere deutlich erhöht werden, so dass niedrigere Schaltspannungen von einigen hundert Volt erreicht werden können. Diese Lösungen beinhalten jedoch deutliche Nachteile, die in einer wesentlichen Verschlechterung der Verarbeitungseigenschaften, in einer Veränderung der mechanischen Eigenschaften der Elastomere (Versteifung) und in Problemen der homogenen Verteilung der Nanopartikel in der Elastomermatrix liegen. Nanopartikel können aggregieren, agglomerieren und zu Problemen bei der Bildung homogener Elastomerfilme führen. Weiterhin sind Nanopartikel der genannten anorganischen Materialien durch ihre hohe innere Oberfläche in der Regel hochreaktiv und können somit zu einer Destrukturierung oder einer Schädigung der Elastomermatrix führen. Weiterhin stellen die Wechselwirkungen an der Grenzfläche Nanopartikel/Elastomermatrix ein häufiges, nicht einfach zu lösendes Problem bei der Anwendung von Nanopartikeln zur Erhöhung der Permittivität von dielektrischen Elastomeren dar.

Aktoren, die aus weichen dielektrischen Elastomeren bestehen, verformen sich aufgrund des Maxwelldrucks $\sigma_{Maxwell}$, der vom elektrischen Feld induziert wird und mit den mechanischen Eigenschaften des Materials wechselwirkt.

$$s_z = \frac{\sigma_{\mathrm{Maxwell}}}{E} = \frac{\varepsilon_0 \varepsilon_r E_b^2}{E} = \frac{\varepsilon_0 \varepsilon_r \left(\frac{U_b}{d}\right)^2}{E}$$

Hierbei sind $s_z$ die maximale Verformung in z-Richtung, $\sigma_{Maxwell}$ der elektrostatische Druck von den Elektroden, $E$ das Elastizitätsmodul des Materials, $\varepsilon_0$ die Permittivität des Vakuums, $\varepsilon_r$ die relative Permittivität des Materials, $E_b$ die Durchbruchsfeldstärke, $U_b$ die Durchbruchsspannung und $d$ die Dicke des aktiven Materials. Aus der oberen Gleichung kann entnommen werden, dass zum Erreichen großer Dehnungen und niedriger Spannungen die relative Permittivität erhöht und der Elastizitätsmodul reduziert werden muss. Die Dicke des elektrischen Films kann ebenfalls reduziert werden, wird jedoch durch die technischen Möglichkeiten eingeschränkt. Die zurzeit geringste Schichtdicke, die zu Aktorikzwecken verwirklicht wurde, liegt bei ungefähr 5 $\mu$m.

Wissenschaftler haben bis heute versucht, existierende Elastomere durch das Hinzufügen von weiteren Komponenten, wie Füllpartikeln, zu modifizieren. Hierfür wurden elektrisch nicht leitfähige und leitfähige Partikel benutzt. Der Vorteil der Einfachheit der Modifizierung von bereits existierenden Elastomeren hat zu vielen unterschiedlichen Herangehensweisen in der Materialforschung geführt.

Als keramische, dielektrische Partikel können $TiO_2$, $BaTiO_3$, PMN-PT (Blei-Magnesium-Niobat mit Bleititanat) oder andere Materialien verwendet werden. Diese Keramiken sind für ihre hohen Permittivitäten bekannt, die typischerweise mehrere Größenordnungen größer sind als die Permittivität des amorphen Elastomers. Die direkte Dispersion der Partikel hat zu unklaren Ergebnissen geführt. Es wurden zum einen Verbesserungen und zum anderen Verschlechterungen in der maximalen Aktorauslenkung erzielt. Dies ist auf die relativ geringe Erhöhung der Permittivität des Komposits und der gleichzeitigen starken Erhöhung des Elastizitätsmoduls durch die Partikelzugabe zurückzuführen. Eine weitere Möglichkeit der Senkung des Elastizitätsmoduls ist die Hinzugabe von Weichmachern. Die Verwendung von Tensiden führt zu einer verbesserten Dispersion der Partikel und verhindert deren Agglomeration. Somit können auch Partikel mit einem Durchmesser von nur 15 nm verwendet werden. Die schlechte Beschaffenheit der meisten Komposite führte jedoch dazu, dass mögliche Anwendungen dieser Materialien als Aktoren nicht weiter verfolgt wurden. Durch die Modifizierung der Oberfläche der Nanopartikel mit Silanen wurde die Sensivität ($\varepsilon_0\varepsilon_r$/E)der Kompositaktoren nur um 50% verbessert.

Elektrisch leitfähige Partikel wurden ebenfalls verwendet, In ersten Versuchen wurden Farbstoffe und leitfähige Polymere verwendet. Eine spätere Veröffentlichung ließ Zweifel bezüglich der Permittivitätserhöhung aufkommen. Die Erhöhung der Permittivität in CuPc-PU-Kompositen z.B. war die Folge einer unvollständigen chemischen Reaktion. Eine Arbeit, die auf der zufälligen Verteilung von elektrisch leitfähigen Carbon Black-Partikeln in einem thermoplastischen Elastomer basiert, führte zu einer starken Erhöhung der Permittivität aber auch gleichzeitig zu einer stark verminderten Durchbruchsfeldstärke. In einer anderen Arbeit wurde ein halbleitendes Polymer (Poly(3-hexylthiophen)) mit einem chemisch verlinkenden Silikon vermischt. Daraus resultierte eine Erhöhung der Permittivität sowie eine Verminderung des Elastizitätsmoduls. In allen zuvor erwähnten Fällen wurde neben den erzielten Verbesserungen auch immer die Durchbruchsfeldstärke stark verringert. Dies begrenzt sehr stark die maximale Aktorauslenkung. In einer kürzlich erschienenen Publikation wurde gezeigt, dass die Anfügung eines leitfähigen Polymers an die Hauptkette des Elastomers nur sehr wenig Einfluss auf die Durchbruchsfeldstärke hat. Dieser Ansatz führte außerdem zu einer starken Erhöhung der Aktoreigenschaften, wobei aber auch die dielektrischen Verluste in einem geringen Maße erhöht wurden.

Dielektrische Elastomeraktoren (DEA) sind elektroaktive Polymere, die sich durch das Anlegen einer Aktivierungsspannung stark verformen können. Daher werden sie auch oft als "künstliche Muskeln" bezeichnet. Diese Bauteile (US 5,977,685, US 7,719,164 B2, US 6,545,384 B1, US 6,689,288 B2, US 7,224,106 B2) bestehen im einfachsten Fall aus einem elastischen Dielektrikum mit der Dicke *d*, das sich zwischen zwei dehnbaren Elektroden befindet. Diese Technologie hat viele praktische Vorteile gegenüber konventionellen Aktoren:

- hohe spezifische elektromechanische Energie,
- deformationsbasierte Bewegung und dadurch kontinuierliche, ruckelfreie Auslenkung,
- geräuschlos,
- hohe Effizienz durch die direkte Kopplung an das Spannungssignal, sowie
- weiche Materialien und dadurch geringe Empfindlichkeit gegenüber Stößen.

Diese dielektrischen Elastomerwandler können aufgrund Ihres Funktionsprinzips ebenfalls in der Sensorik und beim sog. "Energy-Harvesting" eingesetzt werden. Beide Anwendungsfelder haben ein großes Potential. Besonders in der Sensorik gibt es viele verschiedene Anwendungen, die marktreif sind.

Die derzeitigen Nachteile dieser Aktorsysteme sind die hohen Betriebsspannungen von mehreren tausend Volt. Aus diesem Grund werden Materialien mit hoher Permittivität $\varepsilon_r$, hoher Durchbruchsfeldstärke $E_b$ und niedrigem Elastizitätsmodul $E$ gesucht, um die maximale Ausdehnung $s_z$ zu erhöhen und die Betriebsspannung $U$ zu erniedrigen.

Aus der EP 0 415 278 A1 sind endständig ethylenisch ungesättigte Verbindungen sowie ihre Verwendung in der nichtlinearen Optik bekannt.

Die US 5,298,588 offenbart Organo-Silicium-Polymere, die quervernetzte Polymere und quervernetzbare Präpolymere auf Basis von zyklischen Polysiloxanen, organischen Farbstoffen und ggf. Polyenen umfassen.

F.-B. Meng et al. beschreiben in Colloid Polym. Sci. (2008) 286:873-879 die Synthese und Charakterisierung von spezifisch substituierten flüssigkristallinen Polysiloxanen, die fluorierte Einheiten beinhalten.

In Macromol. Chem. 183, 2311 - 2321 (1982) beschreiben M. Portugall et al. die Synthese sowie das Phasenverhalten von flüssigkristallinen Polyacrylaten.

H. Finkelmann et al. untersuchen in Macromol. Chem., Rapid Commun., 2, 317 - 322 (1981) flüssigkristalline Polysiloxane als neuen Typus eines flüssigkristallinen Materials.

Aus der US 2003/0052576 A1 sind polymere Blends, mit einer dualen Funktionalität als Sensor bzw. Aktuator bekannt.

Ausgehend hiervon ist es daher Aufgabe der vorliegenden Erfindung, ein für ein Dielektrikum geeignetes Polymermaterlal mit einer hohen Permittivität, hoher Durchbruchsfeldstärke und niedrigem Elastizitätsmodul anzugeben, das bei niedrigeren Spannungen betrieben werden kann.

Diese Aufgabe wird mit den Merkmalen des Patentanspruchs 1, betreffend die Verwendungszwecke eines

Polymermaterials gelöst. Die jeweiligen abhängigen Patentansprüche stellen dabei vorteilhafte Weiterbildungen dar. Erfindungsgemäß wird somit die Verwendung eines Polymers , das einen kovalent an das dem Polymer zugrunde liegenden Polymergerüst gebundenen Dipol gemäß der allgemeinen Formel I aufweist,

$$-(R)_n-D-X-(A)_m$$

Formel I

wobei

A eine Elektronenakzeptorfunktionalität, ausgewählt aus der Gruppe bestehend aus $-NO_2$, -CN, -F, $-CF_3$, Cyanovinyl-, Dicyanovinyl-, oder Tricyanovinyl-Resten,

X ein organischer Rest mit einem delokalisierten Elektronensystem, das eine Delokalisierung, z.B. über ein IT-Elektronensystem, der Elektronen zwischen D und A ermöglicht,

D eine Elektronendonorfunktionalität, ausgewählt aus der Gruppe bestehend aus -O- oder -N(B)-, wobei B Wasserstoff oder ein linearer oder verzweigter Alkylrest mit 1 bis 16 Kohlenstoffatomen ist,

R ein Alkylenrest mit 1 bis 16 Kohlenstoffatomen, bevorzugt 2 bis 8 Kohlenstoffatomen, insbesondere 2 oder 3 Kohlenstoffatomen repräsentiert, sowie

n = 0 oder 1 und

m = 1, 2, 3 oder 4 ist,

als Dielektrikum, als elastisches Dielektrikum, als Aktuator, als künstlicher Muskel, als Dielektrikum für flexible elektronische Bauteile, insbesondere Kondensatoren, wie z. B. weiche Kondensatoren, bereitgestellt.

Die Anbindung des Dipols an das Polymergerüst erfolgt dabei über den Rest R (für den Fall, dass n = 1) oder über den Donor D (für den Fall, dass n = 0).

Überraschenderweise hat sich gezeigt, dass die erfindungsgemäßen Polymere eine deutlich erhöhte Permittivität im Vergleich zu aus dem Stand der Technik bekannten dielektrischen Elastomeren aufweisen. Die Permittivität kann dabei beispielsweise bei 0,1 Hz oder auch bei 1 Hz bestimmt werden. Das Messverfahren zur Bestimmung der Permittivität erfolgt dabei nach D. N. Mc Carthy, S. Risse, and P. Katekomol and G. Kofod, The effect of dispersion on the increased relative permittivity of TiO2/SEBS composites, J. Phys. D: Appl. Phys. 42, p. 145406, 2009. doi: 10.1088/0022-3727/42/14/145406. Die Bestimmung der Permittivität erfolgt dabei nach folgenden typischen Messverfahren. Zuerst wird der Polymerfilm im Tropf-Gieß-Verfahren auf ein Glassubstrat mit gesputterter Goldelektrode (Ø 10 mm) aufgebracht. Nach der Verfilmung wird die Filmdicke mittels einer Mikrometerschraube durch Differenzmessung bestimmt. Anschließend wird eine Elektrode aus Goldpulver mit Hilfe einer Maske aufgetragen. Dies verbessert den elektrischen Kontakt zwischen Film und massiver Metallelektrode, die im Anschluss auf den Film aufgelegt wird. Die dielektrischen Größen Leitfähigkeit ($\sigma$), Permittivität ($\varepsilon_r$), dielektrischer Verlust ($\varepsilon''$) und dielektrischer Verlustfaktor ($\tan(\delta)$) werden in einem Frequenzintervall von 0.1 Hz bis 10 MHz gemessen. Insbesondere hat sich gezeigt, dass die Permittivität, gemessen bei 0,1 Hz, dabei mindestens 4,0, bevorzugt mindestens 5,0, besonders bevorzugt mindestens 6,0 beträgt. Sogar höhere Werte können erzielt werden.

Erfindungsgemäß kann die Zielstellung somit z.B. durch hochpermittive Elastomere, insbesondere auf PU- und PDMS-Basis, durch die kovalente Anknüpfung sog. organischer Dipolmoleküle erreicht werden. Als geeignete organische Dipole kommen erfindungsgemäß vorzugsweise solche mit aromatischer oder heteroaromatischer Grundstruktur in Frage, die durch geeignete Donor- und Akzeptorgruppen an geeigneter Stelle substituiert werden.

Dabei können die Dipolmoleküle beispielsweise terminal an das Polymergerüst angebunden sein; jedoch ist ebenso alternativ oder zusätzlich hierzu auch eine Anbindung der Dipolmoleküle in einem nicht-terminalen Teil des Polymergerüsts möglich.

Eine bevorzugte Ausführungsform sieht vor, dass der Dipol durch die allgemeine Formel II repräsentiert ist:

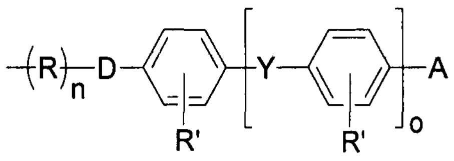

Formel II

wobei

A, D, R und n die oben angegebene Bedeutung haben und

R' jeweils unabhängig ausgewählt ist aus der Gruppe bestehend aus Wasserstoff, linearen oder verzweigten Alkylresten mit 1 bis 18 Kohlenstoffatomen sowie aromatischen Resten,

Y eine chemische Bindung repräsentiert oder ausgewählt ist aus der Gruppe bestehend aus cis- oder trans-1,2-Ethendiyl, Ethindiylresten, einer Diazogruppe oder einer 1,2-Azomethindiylgruppe, sowie

o = 0 bis 10, bevorzugt 1, 2 oder 3 ist.

Erfindungsgemäße Gehalte des Dipols, bezogen auf das Polymer, liegen dabei zwischen 1 und 50 Gew.-%, bevorzugt zwischen 1 und 20 Gew.-%, besonders bevorzugt zwischen 5 und 10 Gew.-%.

Erfindungsgemäß liegt dem Polymergerüst ein Elastomer zugrunde. Dieses Elastomer ist dabei ausgewählt aus der Gruppe bestehend aus linearen oder vernetzten Polysiloxanen, wobei der Dipol kovalent an ein Siliciumatom angebunden ist; Polyurethanen und Polybutadienkautschuken. Bei der zuvor genannten Möglichkeit, dass das Dipolmolekül an ein Polyurethan angeknüpft ist, ist beispielsweise eine kovalente Bindung zwischen einer das Polyurethan terminierenden Isocyanat- oder Hydroxy-Funktionalität gegeben, hierzu weist das Dipolmolekül spezifische Funktionalitäten auf, die mit diesen reaktiven Funktionalitäten des Polyurethans reagieren können. Bei der Möglichkeit, das Dipolmolekül an Polybutadienkautschuke anzuknüpfen, bietet sich an, das Dipolmolekül beispielsweise mit vinylischen Funktionalitäten auszurüsten, die gegenüber den vinylischen Funktionalitäten in den jeweiligen Kautschuken reagieren können. Besonders vorteilhaft ist jedoch, wenn das Polymergerüst auf einem Polysiloxan basiert.

Für diesen Fall ist es bevorzugt, wenn das Polysiloxan 3 bis 1000 Siliciumatome, bevorzugt 3 bis 100 Siliciumatome, insbesondere 3 bis 40 Siliciumatome, aufweist. Wie aus der voranstehenden Definition ersichtlich ist, wird ebenso bereits ein Siloxan, das lediglich drei Si-Atome aufweist, d.h. das ein z.B. von Octamethyltrisiloxan abgeleitetes Gerüst aufweist, als Polysiloxan bezeichnet.

Bevorzugte Polysiloxane sind dabei ausgewählt aus der Gruppe bestehend aus Polydialkylsiloxanen sowie Polyalkylsiloxanen, die teilweise Wasserstofffunktionalisiert sind, wobei das Verhältnis der Wasserstofffunktionalisierungen zur Gesamtheit aus Wasserstofffunktionalisierungen und Alkylresten bevorzugt zwischen 0,01 und 1,5, weiter bevorzugt zwischen 0,1 und 1 beträgt. Die zuvor angegebene Definition für die Wasser-Funktionalisierung der teilweise Wasserstoff-funktionalisierten Polysiloxane entspricht dabei dem Verhältnis der im Siloxan an die Si-Atome gebundenen Wasserstoffatome zur Gesamtzahl der vorhandenen Bindungsstellen für Alkyl- bzw. Wasserstoffreste, mit anderen Worten, der Gesamtheit der Bindungen der Si-Atome, mit Ausnahme der Bindungen zu den Sauerstoff-Atomen. Definitionsgemäß weisen somit die zuvor genannten "Polydialkylsiloxane", die im Sinne der Erfindung mit einem Dipol funktionalisiert sind, ein oder mehrere kovalent an Siliciumatome gebundene Dipolmoleküle auf. Alle weiteren Bindungen der Siliciumatome, die nicht Bindungen zu Sauerstoffatomen darstellen, sind Bindungen zu Alkylgruppen. Die gleiche Definition gilt auch für die "teilweise Wasserstoff-funktionalisierten" Polyalkylsiloxane" mit der oben bereits angegebenen Maßgabe, dass ein Teil der Alkylreste durch Wasserstoffatome ersetzt ist.

Erfindungsgemäß kann ebenso ein Blend verwendet werden, der mindestens eine Sorte eines voranstehend beschriebenen Polymers enthält. Der Blend enthält dabei zumindest eine Sorte eines beliebigen weiteren nicht mit einem Donor funktionalisierten Polymeren. Bevorzugt ist dabei, dass das mindestens eine weitere Polymer ausgewählt ist aus der Gruppe bestehend aus Elastomeren, insbesondere linearen oder vernetzten Polyalkylsiloxanen, linearen oder vernetzten partiell wasserstofffunktionalisierten Polysiloxanen, Polyurethanen, Polybutadienkautschuken und/oder Poly(meth)acrylaten.

Es wird ebenso ein Verfahren zur Herstellung eines vorstehend beschriebenen erfindungsgemäßen Dipolsubstituierten Polymeren angegeben, bei dem ein reaktives Dipolmolekül der allgemeinen Formel III

Formel III $$Z\left(R''\right)_n D - X\left(A\right)_m$$

wobei D, X, A, n und m die weiter oben angegebene Bedeutung aufweisen und

R" einen Alkylenrest mit 1 bis 16 Kohlenstoffatomen sowie

Z eine reaktive Funktionalität repräsentiert,

a) mit einem mit der reaktiven Funktionalität Z unter Ausbildung einer kovalenten Bindung reaktiven Polymer zur Reaktion gebracht wird, oder

b) mit einer Sorte oder mehreren Sorten Monomeren und/oder Präpolymeren, wovon mindestens eine Sorte Monomerer und/oder Präpolymerer mit der reaktiven Funktionalität Z unter Ausbildung einer kovalenten Bindung reagieren kann, zur Reaktion gebracht wird, wobei gleichzeitig das Polymergerüst gebildet wird.

Das Verfahren umfasst somit zwei Varianten, wonach gemäß der dargestellten Variante a) das reaktive Dipolmolekül mit einem bereits auspolymerisierten Polymer zur Reaktion gebracht wird. Bei dieser Verfahrensvariante wird das reaktive Polymer mit dem reaktiven Dipolmolekül "dotiert", indem das Dipolmolekül an das Polymergerüst angeknüpft wird. Derartige reaktive Polymere werden auch als Vernetzer bezeichnet.
Gemäß der Verfahrensvariante b) wird das reaktive Dipolmolekül zu einer Mischung mehrerer reaktiver Sorten von Monomeren, Präpolymeren, etc., gegeben, wonach im Anschluss diese Mischung auspolymerisiert wird, d.h. sich das erfindungsgemäße Polymer erst bildet. Auch hier findet eine Anknüpfung des Dipolmoleküls an das Polymergerüst statt. Auch die Präpolymeren können als Vernetzer bezeichnet werden.
Dabei ist die reaktive Funktionalität Z jeweils auf den eingesetzten Polymertyp und darin enthaltene funktionelle reaktive Gruppen abgestimmt. Insbesondere ist Z ausgewählt aus der Gruppe bestehend aus Wasserstoff, Vinyl-, Allyl-, - OH, -SH, -NH2, -COOH oder -CNO-Gruppen.
In einer besonders bevorzugten Ausführungsform des Verfahrens weist das reaktive Polymer, das Monomer und/oder das Präpolymer eine mit der reaktiven Funktionalität Z reagierende funktionelle Gruppe auf, die ausgewählt ist aus der Gruppe bestehend aus

- $-O-Si(H)_p(R''')_{3-p}$, wobei R'" ausgewählt Ist aus der Gruppe bestehend aus linearen oder verzweigten Alkylresten mit 1 bis 18 Kohlenstoffatomen und p 1, 2 oder 3 ist,
- $-O-Si(H)_q(R''')_{2-q}-$, wobei R'" die oben angegebene Bedeutung aufweist und q 1 oder 2 ist,
- $-N(H)_q(R''')_{2-q}$, wobei R"' und q die oben angegebene Bedeutung haben, sowie
- -OH, -CNO, -COOH oder -COOX mit X = Cl, Br, R'", sowie
- reaktiven Doppelbindungen.

Diese zuvor genannte Ausführungsform hat Gültigkeit für beide der weiter oben unter a) und b) genannten Verfahrensvarianten. Die erste der zuvor genannten Varianten stellt dabei eine terminale Silan-Gruppierung dar, die zumindest ein Wasserstoffatom aufweist. Die zweite Variante betrifft dabei eine in die Polymerkette eingebundene Silan-Funktionalität, die zumindest ein Wasserstoffatom aufweist. Mit diesen Silan-Funktionalitäten ist beispielsweise über den Reaktionsmechanismus einer Hydrosilylierung ein Anbinden des Dipolmoleküls möglich. Für diesen Fall kann die reaktive Funktionalität beispielsweise ausgewählt sein aus Funktionalitäten, die eine Doppelbindung aufweisen; insbesondere kommen hierzu Vinyl- oder Allylgruppen in Frage. Ebenso ist ein Anbinden über einen Reaktionsmechanismus denkbar, bei dem z.B. eine reaktive -SiH-Funktionalität eines Siloxans mit einem Dipolmolekül mit einer Hydroxy-Funktionalität unter Verwendung eines Katalysators und Eliminierung von Wasserstoff umgesetzt wird. In diesem Fall wird eine neue Si-O-Bindung ausgebildet. Die beiden nachfolgend genannten Gruppen von Funktionalitäten treten beispielsweise bei Polyurethanen oder Polyacrylsäure-Derivaten auf. Um mit diesen Funktionalitäten reagieren zu können, weisen die reaktiven Dipolmoleküle bevorzugt Funktionalitäten auf, die ausgewählt sind aus Säure-Funktionalitäten, alkoholischen oder Amino-Funktionalitäten, um beispielsweise mit den zuvor genannten Gruppen der Polymeren bzw. Präpolymeren und/oder Monomeren durch Kondensation reagieren zu können.
Polymere bzw. Monomere oder Präpolymere, die reaktive Doppelbindungen aufweisen, sind beispielsweise bei Polybutadienkautschuken vorhanden. Eine Anbindung der reaktiven Dipolmoleküle an diese Funktionalitäten ist beispielsweise über radikalische Reaktionsmechanismen möglich. Hierzu ist es bevorzugt, wenn die reaktiven Dipolmoleküle ebenso Doppelbindungen, wie beispielsweise Vinyl- oder Allyl-Funktionalitäten aufweisen.
In einer weiter bevorzugten Variante wird dem Reaktionsgemisch mindestens ein weiteres Monomer, Präpolymer und/oder Polymer beigemischt, das gegenüber dem reaktiven Dipolmolekül unreaktiv und gegenüber dem reaktiven Polymer, Präpolymer und/oder Monomer reaktiv ist. Diese Variante sieht weiter vor, dass bei dem erfindungsgemäßen Verfahren ein Copolymer gebildet wird. Die weiter dem Reaktionsgemisch zugefügten Bausteine reagieren dabei lediglich mit der ersten Sorte von Polymeren bzw. Präpolymeren bzw. Monomeren, aber nicht mit den zugesetzten Dipolmolekülen.

Gemäß der zuvor beschriebenen Ausführungsform ist es bevorzugt, wenn das weitere Monomer, Präpolymer und/oder Polymer ausgewählt ist aus der Gruppe bestehend aus vinylterminierten Siloxanen, vinylterminierten Alkylsiloxanen und/oder vinylterminierten Dialkylsiloxanen.

Eine weiter bevorzugte Ausführungsform sieht vor, dass das Verfahren unter Zugabe eines Katalysators, bevorzugt eines Platinkatalysators, erfolgt. Insbesondere für den Fall, dass eine Hydrosilylierung durchgeführt wird, sind aus dem Stand der Technik bekannte Platinkatalysatoren bevorzugt, um hohe Umsatzraten und Ausbeuten zu erzielen.

Weiter ist es bevorzugt, wenn die Umsetzung des reaktives Dipolmoleküls mit dem reaktiven Polymeren, Monomeren und/oder Präpolymeren in einem Lösungsmittel, bevorzugt in Chloroform, Pentan, Hexan, Cyclopentan, Cyclohexan, Dichlormethan und/oder Siliconen durchgeführt wird.

Zur Herstellung eines zuvor beschriebenen Blends verschiedener Polymere wird in einer weiteren Variante während und/oder im Anschluss an ein vorstehend beschriebenes Verfahren zur Reaktionsmischung und/oder dem erhaltenen Polymer mindestens ein weiteres unmodifiziertes Polymer zugeblendet.

Erfindungsgemäß wird ebenso ein Formkörper bereitgestellt, der ein eingangs beschriebenes Polymer bzw. einen Blend hieraus enthält. Insbesondere für den Fall, dass dem Polymer bzw. Blend elastomere Materialien zugrunde liegen, kann dieser Formkörper in Form eines elastischen Filmes, eines elektronischen Bauteils, eines Dielektrikums, eines künstlichen Muskels und/oder eines Aktuators, wie vorgestreckte Aktuatoren und/oder Stapelaktuatoren, ausgebildet sein.

Beispielsweise kann der Polymerfilm durch ein gängiges formgegebenes Verfahren aus einer Lösung des Polymerfilms (oder eines Blends hiervon), insbesondere durch Rakeln, Dip-Coating, Drucken oder Casting, in eine entsprechende Form gebracht werden. Das Aushärten des Films erfolgt dabei bei erhöhten Temperaturen, beispielsweise zwischen 50 und 180 °C, insbesondere zwischen 80 und 120 °C.

Die vorliegende Erfindung wird anhand der nachfolgenden Ausführungsformen sowie Beispiele näher beschrieben, ohne die Erfindung auf die dort dargestellten speziellen Parameter zu beschränken.

Zur kovalenten Einbindung in das jeweilige Elastomere können die oben beschriebenen Dipole donor- oder akzeptorseitig beispielsweise mit Vinyl- oder Allylgruppen (zur Einbringung z.B. in PDMS) bzw. mit Hydroxy- oder Aminogruppen (zur Einbringung z.B. in PU) funktionalisiert werden, damit sie zum kovalenten Einbau in das jeweilige Elastomernetzwerk befähigt sind.

Die Einbindung kann erfindungsgemäß zum einen dadurch erreicht werden, dass in einem one-shot-Verfahren alle Komponenten inklusive der organischen Dipole miteinander gemischt, verfilmt und zur Reaktion gebracht werden. Weiterhin ist die Herstellung von Präpolymeren aus den organischen Dipolen und einzelnen Komponenten der PDMS- oder PU-Elastomere möglich, deren Produkte dann später zum finalen Elastomernetzwerk umgesetzt werden. Dabei kann die Herstellung der Präpolymere aus den organischen Dipolen und einzelnen Komponenten der Elastomere in der Art und Weise geschehen, dass deren Funktionalität vollständig abgesättigt wird und die dann nicht mehr reaktiven Präpolymere als hochverträgliche Komponente dem Elastomeransatz in beliebigen Verhältnissen zugemischt werden. Die Präpolymerherstellung kann jedoch in der Art und Weise erfolgen, dass eine Restfunktionalität verbleibt, die dann den kovalenten Einbau in das Elastomernetzwerk gestattet.

Der Gehalt an organischem Dipol kann in breiten Grenzen durch die Wahl des Mischungsverhältnisses unter Beachtung der Stöchiometrie der Komponenten variiert werden. Dadurch lassen sich Dipolgehalte im Bereich von 0 bis 20 Masse-%, vorzugsweise 1 bis 10 Masse-%, realisieren, die zu Permittivitäten $\varepsilon_r$ von deutlich über 5 führen.

In den folgenden Beispielen wird die Herstellung hochpermittiver Elastomerfilme beschrieben:

**Beispiel 1**

Synthese der Dipolstruktur Dip-3

Der verwendete Dipol N-Allyl-N-methyl-p-nitroanilin (Dip-3) wird durch direkte Allylierung des entsprechenden Anilins mit Allylalkohol hergestellt.

Hierfür werden 5,0 g (0,0329 mol) N-Methyl-p-nitroanilin und ein Überschuss von 5 mL Allylalkohol (0,0735 mol) in 200 mL absolutem Benzol gelöst, das über 8 g Molsieb MSA4 steht. Für die katalysierte Reaktion fügt man 0,07 g (0,33 mmol) Palladium-(II)-acetat, 2,5 mL (8,4 mmol) Titan-(IV)-isopropyloxid und 0,34 g (1,31 mmol) Triphenylphosphin hinzu. Das Gemisch wird unter Rühren bei 75 °C für 12 Stunden unter Rückfluss in einer Argonatmosphäre erhitzt. Anschließend wird die Lösung gefiltert und säulenchromatographisch (Silica-Gel) in Essigester:n-Hexan = 1:4 getrennt, was zu 5,94 g (94,0 %) eines gelben Öls als Produkt führt, welches im Kühlschrank kristallisiert. Der Schmelzpunkt liegt

bei $T_{Schmelz}$ = 38 bis 40 °C.

**Beispiel 2**

Synthese der Dipolstruktur Dip-4

Der Dipol N-Allyl-N-methyl-4-(4'-nitrophenylazo)-anilin wird in einer Zweistufen-Reaktion hergestellt. Hierfür wird zunächst die erste Komponente Allylfunktionalisiert, um anschließend über eine Azokupplung zum gewünschten Dipol umgesetzt zu werden.

Die Allylierung erfolgt auf dem gleichen Weg, wie in der Vorschrift von Beispiel 1 beschrieben. 10,35 g (0,0966 mol) N-Methylanilin werden mit einem Überschuss an Allylalkohol Palladium-katalysiert umgesetzt. Das Reaktionsgemisch wird säulenchromatographisch im Laufmittel n-Hexan:Essigester = 4:1 aufgearbeitet. Als Produkt erhält man 9,87 g (64,4 %, 0,0671 mol) eines orange-farbigen Öls.

In einem zweiten Reaktionsschritt wird das hergestellte Produkt, in verdünnter Salzsäure gelöst. 9,83 g (0,0415 mol) des Diazoniumsalzes 4-Nitrobenzoldiazoniumtetrafluoroborat werden ebenfalls in einer zweiten Salzsäurelösung vorgelegt. Die Lösungen werden unter Kühlen bei T = -5°C vereint, wodurch eine starke Rotfärbung der Lösung entsteht, woraufhin mit Natriumacetat ein pH-Wert von 4 eingestellt wird. Hierdurch fällt ein voluminöser Niederschlag aus, der abfiltriert und mehrmals mit Wasser gewaschen wird. Der Feststoff wird in Ethanol umkristallisiert, wodurch 11,0 g (90%, 0,0371 mol) des Produktes als grünlich glänzende Nadeln ausfallen. Der Schmelzpunkt $T_{Schmelz}$ liegt bei 119 bis 121 °C.

**Beispiel 3**

Synthese des langkettigen Füllstoffes x301-3

Um die ausgewählte Dipolstruktur in das Netzwerk zu integrieren, wird der Dipol 3 über eine Platin-katalysierte Hydrosilylierung an einen Vernetzer gebunden, der aus einer langkettigen PDMS-Kette, welche partiell Hydridfunktionalisiert ist, besteht. Man setzt den Vernetzer (hier bestehend aus 27 SiO-Einheiten), komplett mit Dipolen um, so dass ein unreaktives, mit Dipol gesättigtes Molekül bleibt, welches als Füllstoff für die Matrix fungiert. Das eingesetzte PDMS besitzt eine Funktionalität f = 7,51, was bedeutet, dass im Mittel 7,51 reaktive Einheiten pro Kette vorliegen.

Für die Umsetzung werden 1 g Vernetzer (0,513 mmol, 3,8 mmol reakt. Si-H) mit einem leichten Überschuss von 0,85 g Dipol (4,2 mmol) in 15 mL Chloroform gelöst und 0,05 g Pt-Kat. hinzugefügt. Das Gemisch wird bei konstantem Rühren bei einer Temperatur von T = 70 °C unter Rückfluss für 12 Stunden erhitzt und die unlöslichen Reaktionsrückstände abfiltriert. Der reine Füllstoff wird mittels Umfällen in Methanol in einer Ausbeute von 0,26 g (14,9 %, 0,0766 mmol) erhalten.

**Beispiel 4**

Synthese des kurzkettigen Füllstoffes HTMS-3

Der kurzkettige Füllstoff wird über eine Hydrosilylierung von 1,21 g (0,0054 mol) HTMS (ein DMS bestehend aus 3 SiO-Einheiten, f = 1) mit 0,87 g von Dipol 3 (0,00453 mol) gewonnen. Das Gemisch wird entsprechend der Vorschrift aus Beispiel 3 umgesetzt. Die Aufarbeitung erfolgt säulenchromatographisch im Laufmittel Toluol. Man erhält 1,73 g Produkt (92,1 %, 0,0042 mol).

**Beispiel 5**

Synthese des kurzkettigen Füllstoffes HTMS-4

Die Umsetzung erfolgt gemäß der Vorschrift aus Beispiel 3. Es werden 2 g (0,00901 mol) des in Beispiel 4 verwendeten HTMS mit 2,66 g (0,00898 mol) Dipol 4 zur Reaktion gebracht. Nach der chromatographischen Abtrennung des Eduktes (Laufmittel THF:Petrolether = 1:6) wird der Stoff rein durch Umkristallisation mit Ethanol gewonnen. 1,33 g (28,6 %, 0,00257 mol) des Produktes werden isoliert, welches als bronzefarbener metallisch glänzender Feststoff mit einem Schmelzpunkt von $T_{Schmelz}$ = 87-89 °C vorliegt.

**Beispiel 6**

Synthese des reaktiven Füllstoffes $X_{p-}$991-3

Für dieses Beispiel gelten erneut die Versuchsdurchführungen gemäß Beispiel 3.

1,04 g (0,65 mmol, 16,98 mmol reakt. Si-H) eines Vernetzers (28 SiO-Einheiten, f = 26) werden mit 1,21 g (6,30 mmol) Dipol 3, sowie mit 0,71 g Allyltrimethylsilan (6,22 mmol) zur Reaktion gebracht. Hierbei reagieren nicht alle Si-H des Vernetzers. Verbliebene Verunreinigungen (nicht reagierte Edukte, Pt-Kat) werden mit Methanol aus dem modifizierten Vernetzer extrahiert. Man erhält 3,22 g Produkt (97,8 %, 0,67 mmol, f = 5,30).

**Vergleichsbeispiel**

Unmodifizierte Matrix

Die unmodifizierte Matrix ist ein zweikomponentiges System. Das Basismaterial besteht aus einem vinylterminierten PDMS, welches eine Molmasse von M = 28000 $g/mol^{-1}$ besitzt. In Komponente A ist die Matrix zusammen mit dem Katalysator vorgelegt und in Komponente B der partiell hydridfunktionalisierte Vernetzer, welcher sich über eine Hydrosilylierungsreaktion mit dem Netzwerk verbindet. Als Lösungsmittel wird Chloroform verwendet. Die Komponente A und B werden im Verhältnis 3:1 gemischt und vernetzen nach dem Abdampfen bei Raumtemperatur.

**Anwendungsbeispiel 1**

Filmherstellung im one-step-Verfahren:

Im one-step-Verfahren wird eine dritte Komponente C angefertigt, welche in die Matrix des Vergleichsbeispiels eingemischt werden kann. Diese Lösung beinhaltet den Dipol, sowie zusätzlichen Vernetzer, dessen Konzentration dieselbe wie in Lösung B ist. In Lösung C werden alle reaktiven Einheiten durch Dipole kompensiert. Es werden für hochpermittive Filme nun die Lösungen A:B:C im Volumen-Verhältnis 3:1:X (X = 0-6) zusammengemischt. Man lässt das Lösungsmittel abdampfen und verfilmt das Netzwerk 30 Minuten bei einer Temperatur von T = 120°C. Eine Übersicht der mechanischen und dielektrischen Eigenschaften der gemäß dem Anwendungsbeispiel hergestellten Materialien findet sich in Tabelle 1 (Einträge 1-1 bis 1-6).

**Tabelle 1**

| | One-step-Verfahren | | | | Permittivität | | | |
|---|---|---|---|---|---|---|---|---|
| Probe | Komponente A | Komponente B | Komponente C | $\%_{wt}$ Dip | f = 0.1 Hz | f = 1 Hz | | |
| Vergleichsbeispiel | 3 | 1 | 0 | 0 | 3,48 | 3,37 | | |
| 1-1 | 3 | 1 | 1 | 1,9 | 4,12 | 3,37 | | |
| 1-2 | 3 | 1 | 2 | 3,5 | 4,69 | 4,32 | | |
| 1-3 | 3 | 1 | 3 | 5,1 | 5,77 | 5,11 | | |
| 1-4 | 3 | 1 | 4 | 6,5 | 6,92 | 5,86 | | |
| 1-5 | 3 | 1 | 5 | 7,9 | 9,89 | 7,17 | | |
| 1-6 | 3 | 1 | 6 | 9,1 | 13,37 | 8,75 | | |
| | Virgin Sample | | | | Cycled Sample | | | |
| Probe | Min. Elast. Mod. [kPa] | Tear L. [%] | Tear Str. [kP] | Y. Mod. [kPa] | Min. Elast. Mod. [kPa] | Tear L[%] | Tear Str. [kPa] | Y. Mod. [kPa] |
| Vergleichsbeispiel | 1088 | 236 | 3613 | 1704 | 693 | 207 | 3101 | 1535 |
| 1-1 | 632 | 299 | 2918 | 1262 | 492 | 287 | 3016 | 1108 |
| 1-2 | 358 | 397 | 2541 | 868 | 284 | 393 | 2513 | 723 |
| 1-3 | 232 | 421 | 1701 | 611 | 204 | 403 | 1682 | 558 |
| 1-4 | 158 | 516 | 1459 | 524 | 161 | 469 | 1373 | 468 |
| 1-5- | 106 | 358 | 274 | 307 | 105 | 371 | 289 | 252 |
| 1-6 | 72 | 454 | 446 | 340 | 100 | 408 | 484 | 282 |

Wie aus den erhaltenen Ergebnissen des Anwendungsbeispiels 1 ersichtlich ist, weisen die erfindungsgemäßen Elastomere, die Dipol-modifiziert sind, eine wesentlich höhere Permittivität auf, als die Polymere ohne entsprechende Dipol-Modifikation und sind damit den aus dem Stand der Technik bekannten Materialien deutlich überlegen.

**Anwendungsbeispiel 2**

Filmherstellung mit nichtreaktiven Füllstoffen:

Die Polymermatrix (Lösungen A+B) wird entsprechend dem Vergleichsbeispiel gewählt. In Lösung C wird das gewählte Füllstoffmaterial, gelöst in Chloroform, vorgelegt. Die Verfilmung wird nach Anwendungsbeispiel 1 durchgeführt.

**Anwendungsbeispiel 3**

Filmherstellung mit reaktiven Füllstoffen:

Für die Veränderung des Netzwerkes wird Komponente A des Vergleichsbeispiels gewählt. Der Vernetzer aus Komponente B wird durch den reaktiven Füllstoff ersetzt, so dass die gleiche SiH-Konzentration bleibt. Die Verfilmung wird nach Anwendungsbeispiel 1 durchgeführt.

**Patentansprüche**

1. Verwendung eines Polymers mit einem kovalent an das Polymergerüst gebundenem Dipol gemäß der allgemeinen Formel I

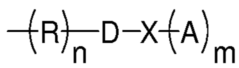

Formel I

wobei

A eine Elektronenakzeptorfunktionalität, ausgewählt aus der Gruppe bestehend aus $-NO_2$, -CN, -F, $-CF_3$, Cyanovinyl-, Dicyanovinyl-, oder Tricyanovinyl-Resten,
X ein organischer Rest mit einem delokalisierten Elektronensystem, das eine Delokalisierung der Elektronen zwischen D und A ermöglicht,
D eine Elektronendonorfunktionalität, ausgewählt aus der Gruppe bestehend aus -O- oder -N(B)-, wobei B Wasserstoff oder ein linearer oder verzweigter Alkylrest mit 1 bis 16 Kohlenstoffatomen ist,
R ein Alkylenrest mit 1 bis 16 Kohlenstoffatomen, bevorzugt 2 bis 8 Kohlenstoffatomen, insbesondere 2 oder 3 Kohlenstoffatomen repräsentiert, sowie
n = 0 oder 1 und
m = 1, 2, 3 oder 4 ist,
wobei das Polymergerüst aus einem Elastomeren, ausgewählt aus der Gruppe bestehend aus linearen oder vernetzten Polysiloxane, wobei der Dipol kovalent an ein Siliciumatom angebunden ist; Polyurethanen und Polybutadienkautschuken gebildet ist,
der Gehalt des Dipols, bezogen auf das Polymer zwischen 1 und 50 Gew.-% beträgt und das Polymer eine Permittivität gemessen bei 0,1 Hz, von mindestens 4,0 aufweist,
als Dielektrikum, als elastisches Dielektrikum, als Aktuator, als künstlicher Muskel, als Dielektrikum für flexible elektronische Bauteile, insbesondere Kondensatoren, wie z.B. weiche Kondensatoren.

2. Verwendung nach Anspruch 1, **dadurch gekennzeichnet, dass** der Dipol durch die allgemeine Formel II repräsentiert ist:

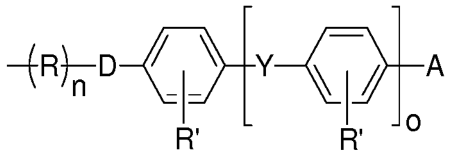

Formel II

wobei

A, D, R und n die oben angegebene Bedeutung haben und
R' jeweils unabhängig ausgewählt ist aus der Gruppe bestehend aus Wasserstoff, linearen oder verzweigten Alkylresten mit 1 bis 18 Kohlenstoffatomen sowie aromatischen Resten,
Y eine chemische Bindung repräsentiert oder ausgewählt ist aus der Gruppe bestehend aus cis- oder trans-1,2-Ethendiyl, Ethindiylresten, einer Diazogruppe oder einer 1,2-Azomethindiylgruppe, sowie
o = 0 bis 10, bevorzugt 1, 2 oder 3 ist.

**3.** Verwendung nach einem der vorhergehenden Ansprüche, **dadurch gekennzeichnet, dass** der Gehalt des Dipols, bezogen auf das Polymer zwischen 1 und 20 Gew.-%, bevorzugt zwischen 5 und 10 Gew.-% beträgt.

**4.** Verwendung nach einem der vorhergehenden Ansprüche, **dadurch gekennzeichnet, dass**
das Polysiloxan 3 bis 1000 Siliciumatome (Si-O), bevorzugt 3 bis 100 Siliciumatome, insbesondere 3 bis 40 Siliciumatome, aufweist, und/oder
das Polysiloxan ausgewählt ist aus der Gruppe bestehend aus Polydialkylsiloxanen sowie Polyalkylsiloxanen, die teilweise Wasserstoff-funktionalisiert sind, wobei das Verhältnis der Wasserstofffunktionalisierungen zur Gesamtheit aus Wasserstofffunktionalisierungen und Alkylresten bevorzugt zwischen 0,01 und 1,5, weiter bevorzugt zwischen 0,1 und 1 beträgt.

**5.** Verwendung nach einem der vorhergehenden Ansprüche, **gekennzeichnet durch** eine Permittivität gemessen bei 0,1 Hz, von mindestens 5,0, bevorzugt mindestens 6,0.

**6.** Verwendung eines Blends, enthaltend mindestens ein Polymer mit einem kovalent an das Polymergerüst gebundenem Dipol gemäß der allgemeinen Formel I

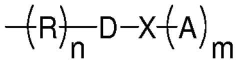

Formel I

wobei

A eine Elektronenakzeptorfunktionalität, ausgewählt aus der Gruppe bestehend aus $-NO_2$, -CN, -F, $-CF_3$, Cyanovinyl-, Dicyanovinyl-, oder Tricyanovinyl-Reseten,
X ein organischer Rest mit einem delokalisierten Elektronensystem, das eine Delokalisierung der Elektronen zwischen D und A ermöglicht,
D eine Elektronendonorfunktionalität, ausgewählt aus der Gruppe bestehend aus -O- oder -N(B)-, wobei B Wasserstoff oder ein linearer oder verzweigter Alkylrest mit 1 bis 16 Kohlenstoffatomen ist,
R ein Alkylenrest mit 1 bis 16 Kohlenstoffatomen, bevorzugt 2 bis 8 Kohlenstoffatomen, insbesondere 2 oder 3 Kohlenstoffatomen repräsentiert, sowie
n = 0 oder 1 und
m = 1, 2, 3 oder 4 ist,
wobei das Polymergerüst aus einem Elastomeren, ausgewählt aus der Gruppe bestehend aus linearen oder vernetzten Polysiloxane, wobei der Dipol kovalent an ein Siliciumatom angebunden ist; Polyurethanen und Polybutadienkautschuken gebildet ist,
der Gehalt des Dipols, bezogen auf das Polymer zwischen 1 und 50 Gew.-% beträgt und das Polymer eine Permittivität gemessen bei 0,1 Hz, von mindestens 4,0 aufweist,
sowie mindestens ein weiteres Polymer, wobei das mindestens eine weitere Polymer ausgewählt ist aus der Gruppe bestehend aus Elastomeren, insbesondere linearen oder vernetzten Polyalkylsiloxanen, linearen oder

vernetzten partiell wasserstofffunktionalisierten Polysiloxanen, Polyurethanen, Polybutadienkautschuken und/oder Poly(meth)acrylaten,
als Dielektrikum, als elastisches Dielektrikum, als Aktuator, als künstlicher Muskel, als Dielektrikum für flexible elektronische Bauteile, insbesondere Kondensatoren, wie z.B. weiche Kondensatoren.

**7.** Formkörper, enthaltend ein Polymer mit einem kovalent an das Polymergerüst gebundenem Dipol gemäß der allgemeinen Formel I

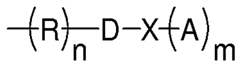

Formel I

wobei

A eine Elektronenakzeptorfunktionalität, ausgewählt aus der Gruppe bestehend aus -$NO_2$, -CN, -F, -$CF_3$, Cyanovinyl-, Dicyanovinyl-, oder Tricyanovinyl-Reseten,
X ein organischer Rest mit einem delokalisierten Elektronensystem, das eine Delokalisierung der Elektronen zwischen D und A ermöglicht,
D eine Elektronendonorfunktionalität, ausgewählt aus der Gruppe bestehend aus -O- oder -N(B)-, wobei B Wasserstoff oder ein linearer oder verzweigter Alkylrest mit 1 bis 16 Kohlenstoffatomen ist,
R ein Alkylenrest mit 1 bis 16 Kohlenstoffatomen, bevorzugt 2 bis 8 Kohlenstoffatomen, insbesondere 2 oder 3 Kohlenstoffatomen repräsentiert, sowie
n = 0 oder 1 und
m = 1, 2, 3 oder 4 ist,
wobei das Polymergerüst aus einem Elastomeren, ausgewählt aus der Gruppe bestehend aus linearen oder vernetzten Polysiloxane, wobei der Dipol kovalent an ein Siliciumatom angebunden ist; Polyurethanen und Polybutadienkautschuken gebildet ist,
oder eines Blends, enthaltend das zuvor angegebene Polymer sowie mindestens ein weiteres Polymer, wobei das mindestens eine weitere Polymer ausgewählt ist aus der Gruppe bestehend aus Elastomeren,
der Gehalt des Dipols, bezogen auf das Polymer zwischen 1 und 50 Gew.-% beträgt und das Polymer eine Permittivität gemessen bei 0,1 Hz, von mindestens 4,0 aufweist,
in Form eines Dielektrikums, eines künstlichen Muskels und/oder eines Aktuators, wie vorgestreckte Aktuatoren und/oder Stapelaktuatoren.

## Claims

**1.** Use of a polymer having a dipole according to the general formula I

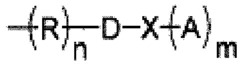

Formula I

covalently bonded to the polymer skeleton,
wherein

A represents an electron-accepting function selected from the group consisting of -$NO_2$, -CN, -F, -$CF_3$, cyanovinyl, dicyanovinyl or tricyanovinyl radicals,
X represents an organic radical having a delocalized electron system that enables delocalization of the electrons between D and A,
D represents an electron-donating function selected from the group consisting of -O- or -N(B)-, wherein B is hydrogen or a linear or branched alkyl radical having 1 to 16 carbon atoms,
R represents an alkylene radical having 1 to 16 carbon atoms, preferably 2 to 8 carbon atoms, especially 2 or 3 carbon atoms, and
n = 0 or 1, and
m = 1, 2, 3 or 4,

wherein the polymer skeleton is made from an elastomer, selected from the group consisting of linear or crosslinked polysiloxanes, wherein the dipole is covalently bonded to a silicon atom; polyurethanes and polybutadiene rubbers,
the content of the dipole is between 1 and 50 wt% based on the polymer and the polymer has a permittivity, measured at 0.1 Hz, of at least 4.0,
as dielectric, as elastic dielectric, as actuator, as artificial muscle, as dielectric for flexible electronic components, especially capacitors, such as, for example, soft capacitors.

2. Use according to Claim 1, **characterized in that** the dipole is represented by the general formula II:

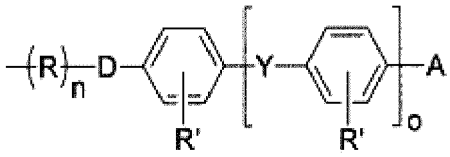

Formula II

wherein

A, D, R and n have the definitions given above, and
R' is in each case independently selected from the group consisting of hydrogen, linear or branched alkyl radicals having 1 to 18 carbon atoms, and aromatic radicals,
Y represents a chemical bond or is selected from the group consisting of cis- or trans-1,2-ethenediyl or ethynediyl radicals, a diazo group or a 1,2-azomethinediyl group, and
o = 0 to 10, preferably 1, 2 or 3.

3. Use according to either of the preceding claims, **characterized in that** the content of the dipole is between 1 and 20 wt%, preferably between 5 and 10 wt%, based on the polymer.

4. Use according to one of the preceding claims, **characterized in that**
the polysiloxane has 3 to 1000 silicon atoms (Si-O), preferably 3 to 100 silicon atoms, especially 3 to 40 silicon atoms, and/or
the polysiloxane is selected from the group consisting of partially hydrofunctionalized polydialkylsiloxanes and polyalkylsiloxanes, wherein the ratio of the hydrofunctionalizations to the sum total of hydrofunctionalizations and alkyl radicals is preferably between 0.01 and 1.5, further preferably between 0.1 and 1.

5. Use according to one of the preceding claims, **characterized by** a permittivity, measured at 0.1 Hz, of at least 5.0, preferably at least 6.0.

6. Use of a blend comprising at least one polymer having a dipole according to the general formula I

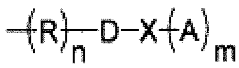

Formula I

covalently bonded to the polymer skeleton,
wherein

A represents an electron-accepting function selected from the group consisting of $-NO_2$, -CN, -F, $-CF_3$, cyanovinyl, dicyanovinyl or tricyanovinyl radicals,
X represents an organic radical having a delocalized electron system that enables delocalization of the electrons between D and A,
D represents an electron-donating function selected from the group consisting of -O- or -N(B)-, wherein B is hydrogen or a linear or branched alkyl radical having 1 to 16 carbon atoms,
R represents an alkylene radical having 1 to 16 carbon atoms, preferably 2 to 8 carbon atoms, especially 2 or 3 carbon atoms, and

n = 0 or 1, and
m = 1, 2, 3 or 4,
wherein the polymer skeleton is made from an elastomer, selected from the group consisting of linear or crosslinked polysiloxanes, wherein the dipole is covalently bonded to a silicon atom; polyurethanes and polybutadiene rubbers,
the content of the dipole is between 1 and 50 wt% based on the polymer and the polymer has a permittivity, measured at 0.1 Hz, of at least 4.0, and at least one further polymer, wherein the at least one further polymer is selected from the group consisting of elastomers, especially linear or crosslinked polyalkyl siloxanes, linear or crosslinked partially hydrofunctionalized polysiloxanes, polyurethanes, polybutadiene rubbers and/or poly(meth)acrylates,
as dielectric, as elastic dielectric, as actuator, as artificial muscle, as dielectric for flexible electronic components, especially capacitors, such as, for example, soft capacitors.

**7.** Moulded article comprising a polymer having a dipole according to the general formula I

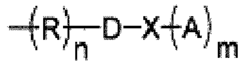

Formula I

covalently bonded to the polymer skeleton,
wherein

A represents an electron-accepting function selected from the group consisting of $-NO_2$, -CN, -F, $-CF_3$, cyanovinyl, dicyanovinyl or tricyanovinyl radicals,
X represents an organic radical having a delocalized electron system that enables delocalization of the electrons between D and A,
D represents an electron-donating function selected from the group consisting of -O- or -N(B)-, wherein B is hydrogen or a linear or branched alkyl radical having 1 to 16 carbon atoms,
R represents an alkylene radical having 1 to 16 carbon atoms, preferably 2 to 8 carbon atoms, especially 2 or 3 carbon atoms, and
n = 0 or 1, and
m = 1, 2, 3 or 4,
wherein the polymer skeleton is made from an elastomer, selected from the group consisting of linear or crosslinked polysiloxanes, wherein the dipole is covalently bonded to a silicon atom; polyurethanes and polybutadiene rubbers,
or a blend comprising the abovementioned polymer and at least one further polymer, wherein the at least one further polymer is selected from the group consisting of elastomers,
the content of the dipole is between 1 and 50 wt% based on the polymer and the polymer has a permittivity, measured at 0.1 Hz, of at least 4.0,
in the form of a dielectric, an artificial muscle and/or an actuator, such as pre-stretched and/or stacked actuators.

## Revendications

**1.** Utilisation d'un polymère comportant un dipôle lié par liaison covalente au squelette polymère selon la formule générale I

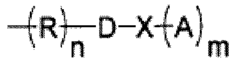

Formule I

dans laquelle

A représente une fonctionnalité accepteur d'électrons, choisie dans le groupe consistant en $-NO_2$, -CN, -F, $-CF_3$, les radicaux cyanovinyle, dicyanovinyle ou tricyanovinyle,

X représente un radical organique comportant un système d'électrons délocalisé, qui permet une délocalisation des électrons entre D et A,
D représente une fonctionnalité donneur d'électrons, choisie dans le groupe consistant en -O- ou -N(B)-, B étant un atome d'hydrogène ou un radical alkyle à chaîne droite ou ramifiée ayant 1 à 16 atomes de carbone,
R représente un radical alkylène ayant 1 à 16 atomes de carbone, de préférence 2 à 8 atomes de carbone, en particulier 2 ou 3 atomes de carbone, ainsi que
n = 0 ou 1, et
m = 1, 2, 3 ou 4,
le squelette polymère étant constitué d'un élastomère choisi dans le groupe consistant en les polysiloxanes à chaîne droite ou ramifiée, le dipôle étant lié par liaison covalente à un atome de silicium ; les polyuréthannes et les caoutchoucs polybutadiènes,
la teneur en le dipôle, rapportée au polymère, étant comprise entre 1 et 50 % en poids, et le polymère présentant une permittivité, mesurée à 0,1 Hz, d'au moins 4,0,
en tant que diélectrique, en tant que diélectrique élastique, en tant qu'actionneur,
en tant que muscle artificiel, en tant que diélectrique pour composants électroniques souples, en particulier des condensateurs, tels que par exemple les condensateurs souples.

**2.** Utilisation selon la revendication 1, **caractérisée en ce que** le dipôle est représenté par la formule générale II

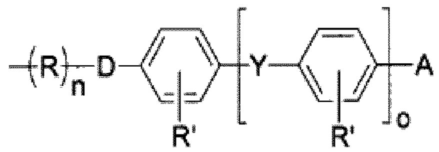

Formule II

dans laquelle

A, D, R et n ont les significations données ci-dessus et
les radicaux R' sont choisis chacun indépendamment de l'autre dans le groupe consistant en l'atome d'hydrogène, les radicaux alkyle à chaîne droite ou ramifiée ayant 1 à 18 atomes de carbone, ainsi que les radicaux aromatiques,
Y représente une liaison chimique, ou est choisi dans le groupe consistant en le radical cis- ou trans-1,2-éthènediyle, les radicaux éthynediyle, un groupe diazo ou un groupe 1,2-azométhinediyle, ainsi que
o = 0 à 10, de préférence 1, 2 ou 3.

**3.** Utilisation selon l'une des revendications précédentes, **caractérisée en ce que** la teneur en le dipôle, rapportée au polymère, est comprise entre 1 et 20 % en poids, de préférence entre 5 et 10 % en poids.

**4.** Utilisation selon l'une des revendications précédentes, **caractérisée en ce que**
le polysiloxane comprend 3 à 1000 atomes de silicium (Si-O), de préférence 3 à 100 atomes de silicium, en particulier 3 à 40 atomes de silicium,
le polysiloxane est choisi dans le groupe consistant en les polydialkylsiloxanes ainsi que les polyalkylsiloxanes, qui ont partiellement subi une fonctionnalisation par l'hydrogène, le rapport entre les fonctionnalisations par l'hydrogène et la totalité des fonctionnalisations par l'hydrogène et des radicaux alkyle étant de préférence compris entre 0,01 et 1,5, plus préférentiellement entre 0,1 et 1.

**5.** Utilisation selon l'une des revendications précédentes, **caractérisée par** une permittivité, mesurée à 0,1 Hz, d'au moins 5,0, de préférence d'au moins 6,0.

**6.** Utilisation d'un mélange contenant au moins un polymère comportant un dipôle lié par liaison covalente au squelette polymère selon la formule générale I

$$-\left(R\right)_n-D-X-\left(A\right)_m$$

Formule I

dans laquelle

A représente une fonctionnalité accepteur d'électrons, choisie dans le groupe consistant en $-NO_2$, -CN, -F, $-CF_3$, les radicaux cyanovinyle, dicyanovinyle ou tricyanovinyle,
X représente un radical organique comportant un système d'électrons délocalisé, qui permet une délocalisation des électrons entre D et A,
D représente une fonctionnalité donneur d'électrons, choisie dans le groupe consistant en -O- ou -N(B)-, B étant un atome d'hydrogène ou un radical alkyle à chaîne droite ou ramifiée ayant 1 à 16 atomes de carbone,
R représente un radical alkylène ayant 1 à 16 atomes de carbone, de préférence 2 à 8 atomes de carbone, en particulier 2 ou 3 atomes de carbone, ainsi que
n = 0 ou 1, et
m = 1, 2, 3 ou 4,
le squelette polymère étant constitué d'un élastomère choisi dans le groupe consistant en les polysiloxanes à chaîne droite ou ramifiée, le dipôle étant lié par liaison covalente à un atome de silicium ; les polyuréthannes et les caoutchoucs polybutadiènes,
la teneur en le dipôle, rapportée au polymère, étant comprise entre 1 et 50 % en poids, et le polymère présentant une permittivité, mesurée à 0,1 Hz, d'au moins 4,0,
ainsi qu'au moins un polymère supplémentaire, le ou les polymères supplémentaires étant choisis dans le groupe consistant en les élastomères, en particulier les polyalkylsiloxanes à chaîne droite ou ramifiée, les polysiloxanes à chaîne droite ou ramifiée, partiellement fonctionnalisés par l'hydrogène, les polyuréthannes, les caoutchoucs polybutadiènes et/ou les poly(méth)acrylates, en tant que diélectrique, en tant que diélectrique élastique, en tant qu'actionneur, en tant que muscle artificiel, en tant que diélectrique pour composants électroniques souples, en particulier des condensateurs, tels que par exemple les condensateurs souples.

**7.** Objet moulé contenant un polymère comportant un dipôle lié par liaison covalente au squelette polymère selon la formule générale I

$$-\left(R\right)_n-D-X-\left(A\right)_m$$

Formule I

dans laquelle

A représente une fonctionnalité accepteur d'électrons, choisie dans le groupe consistant en $-NO_2$, -CN, -F, $-CF_3$, les radicaux cyanovinyle, dicyanovinyle ou tricyanovinyle,
X représente un radical organique comportant un système d'électrons délocalisé, qui permet une délocalisation des électrons entre D et A,
D représente une fonctionnalité donneur d'électrons, choisie dans le groupe consistant en -O- ou -N(B)-, B étant un atome d'hydrogène ou un radical alkyle à chaîne droite ou ramifiée ayant 1 à 16 atomes de carbone,
R représente un radical alkylène ayant 1 à 16 atomes de carbone, de préférence 2 à 8 atomes de carbone, en particulier 2 ou 3 atomes de carbone, ainsi que
n = 0 ou 1, et
m = 1, 2, 3 ou 4,
le squelette polymère étant constitué d'un élastomère choisi dans le groupe consistant en les polysiloxanes à chaîne droite ou ramifiée, le dipôle étant lié par liaison covalente à un atome de silicium ; les polyuréthannes et les caoutchoucs polybutadiènes,
ou d'un mélange contenant le polymère mentionné ci-dessus ainsi qu'au moins un polymère supplémentaire, le ou les polymères supplémentaires étant choisis dans le groupe consistant en les élastomères,
la teneur en le dipôle, rapportée au polymère, étant comprise entre 1 et 50 % en poids, et le polymère présentant une permittivité, mesurée à 0,1 Hz, d'au moins 4,0,

sous forme d'un diélectrique, d'un muscle artificiel et/ou d'un actionneur, tel que les actionneurs précontraints et/ou les actionneurs à empilement.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- US 5977685 A
- US 7719164 B2
- US 6545384 B1
- US 6689288 B2
- US 7224106 B2
- EP 0415278 A1
- US 5298588 A
- US 20030052576 A1


### In der Beschreibung aufgeführte Nicht-Patentliteratur


- **F.-B. MENG et al.** *Colloid Polym. Sci.,* 2008, vol. 286, 873-879
- **M. PORTUGALL.** *Macromol. Chem.,* 1982, vol. 183, 2311-2321
- **H. FINKELMANN et al.** *Macromol. Chem., Rapid Commun.,* 1981, vol. 2, 317-322
- **D. N. MC CARTHY ; S. RISSE ; P. KATEKOMOL ; G. KOFOD.** The effect of dispersion on the increased relative permittivity of TiO2/SEBS composites. *J. Phys. D: Appl. Phys.,* 2009, vol. 42, 145406